# EUROPEAN PATENT SPECIFICATION

(11) **EP 1 634 486 B1**
(45) Date of publication and mention of the grant of the patent: **10.09.2008**
(21) Application number: 04741835.5
(22) Date of filing: 18.06.2004
(51) Int. Cl.: H05K 3/00, H05K 1/14, H05K 1/02, H05K 3/32

(54) **CIRCUIT ASSEMBLY AND METHOD OF ITS MANUFACTURE**
SCHALTUNGSANORDNUNG UND HERSTELLUNGSVERFAHREN
ENSEMBLE DE CIRCUITS ET PROCEDE DE FABRICATION ASSOCIE

(30) Priority: 18.06.2003 DE 10327767
(43) Date of publication of application: 15.03.2006
(73) Proprietor: Ericsson AB, Stockholm (SE)
(72) Inventor: SCHMITT, Reinhold, 71546 Aspach (DE); KONRATH, Willibald, 71554 Cottenweiler (DE); SCHOLL, Klaus, 71522 Backnang (DE); SCHMELCHER, Hailko, 74427 Fichtenberg (DE)
(74) Representative: Stasiewski, Piotr Grzegorz
(86) International application number: PCT/EP2004/051165
(87) International publication number: WO 2004/114734

(56) References cited:
- EP-A- 1 180 918
- EP-A- 1 355 353
- WO-A-03/049513
- FR-A- 2 523 397
- US-A- 4 242 157
- US-A- 5 488 256

## Description

The present invention relates to a circuit assembly comprising a circuit board, at least one circuit component connected to the circuit board by wire bonding, and a base plate, on which the circuit board is mounted. Such circuit assemblies are used in RF technology, e.g. in microwave transmitters/receivers, where circuit parts that operate at low to medium frequencies are frequently assembled on printed circuit boards, whereas for circuit parts that operate at microwave frequencies, ceramic substrates are preferred.

Signal connections between the low to medium frequency circuit parts and the high frequency circuit parts are made by the wire bonding technique known from IC manufacture. It is found that bonding between the circuit board and the RF frequency circuit components frequently yields bond connections of bad quality, having a high transition impedance and/or little mechanical strength. If a circuit assembly that contains such a bad bond does not operate from the start, this is found out during quality inspection, and the assembly may be discarded, or the fault has to be located and corrected. Both options involve considerable costs for the manufacturer. It may be more problematical if such a bad bond causes a failure only after some delay, when the assembly has already been put into use. In such a case, repair or exchange is considerably more laborious, since typically a service technician must be sent to the user in order to find out the cause of the failure, to remove the relevant assembly, et cetera.

US 4 242 157 discloses microwave integrated circuits having a continuous ground plane and dielectric adhesive therebetween. The object of the present invention is, therefore, to provide a circuit assembly having improved reliability, and a method that allows manufacture of such an assembly with a good yield.

The object is achieved by a circuit assembly having the features of claim 1, and a manufacturing method having the features of claim 7, respectively.

The method of manufacture is characterized in that between the conventional step of placing a circuit board and at least one circuit component on a base plate and the step of applying at least one bond wire between the circuit component and a bond pad of the circuit board, a hardenable material is introduced into a gap between them. The gap may result from internal tensions arising when fixing the circuit board to the base plate. By hardening the material in the gap, a positive and integral connection between the circuit board and the base plate is formed.

The method is based on the insight that often the circuit board and the base plate do not touch each other with the required flatness, so that beneath a bond pad, a gap may be present between the circuit board and the base plate which allows the circuit board to yield or to vibrate under the pressure of a bonding tool. This problem is particularly acute in ultrasonic bonding, where the circuit board may be excited to vibrate by the ultrasound applied by the bonding tool. This may hinder the creation of a reliably conductive connection between bond pad and bonding wire.

An insufficient flatness that makes bonding difficult may specifically be caused by the manner in which the circuit board is fixed to the base plate. In particular if the circuit board is screwed to the base plate, it tends to touch the latter only in immediate vicinity of the screws and to warp off the base plate in intermediate regions. By filling the gap at least at selected locations by a hardenable material, which in one embodiment is an electrically conductive adhesive, in accordance with the invention, the circuit board is fixed to the base plate at these locations, so that it neither yields to the pressure of a bonding tool nor vibrates when the filled-in material is hardened.

Preferably, capillary forces between the circuit board and the base plate on the one hand and the hardenable material on the other are made use of for introducing the material into the gap, the material still being in fluid form during the introduction.

The gap may, for example, be filled from an edge the circuit board. Preferably, the material is introduced through a hole in the circuit board, since such a hole may be formed at essentially any location on the circuit board, no matter how far from the edge, where it is desired to support the circuit board by a filling body. The fact that the filling body extends beyond the edges of the hole gives a solid, load-resistant support.

A metallization of the holes is not necessary, so that the circuit board surface necessary to realize them is minimal.

The method may be readily carried out when the hardenable material is an adhesive that is also used in the assembly procedure of the circuit board for cementing circuit components to it. Preferably, the application of the adhesive for cementing these circuit components and the introduction into the gap are canied out in one step during automated assembly of the circuit board.

It is particularly effective if the filling body is located adjacent to a bond pad which is fixed in this way. Preferably, at least two filling bodies are provided at different sides of the bond pad.

Further features and advantages of the invention become apparent by way of example from the subsequent description of an embodiment referring to the appended figures.
Fig. 1 is a perspective schematic view of a circuit assembly according to the present invention; and
Figs. 2A to 2D are sections of the circuit assembly of Fig. 1 along line II-II in Fig. 1 in various stages of the manufacture of the assembly.

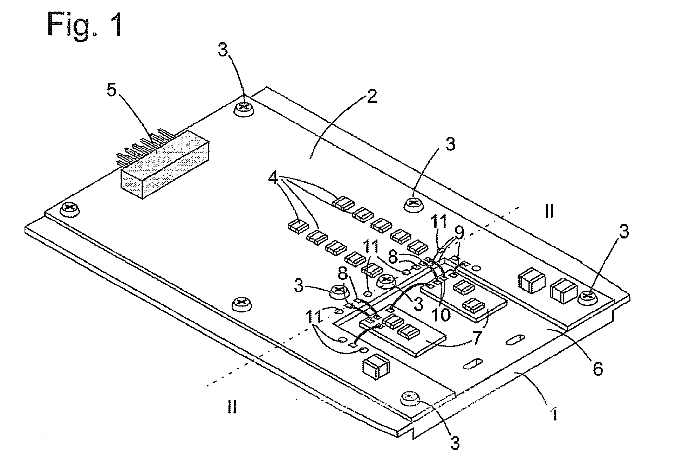

The assembly shown in perspective in Fig. 1 comprises a base plate 1 of metal on which a printed circuit board 2 is mounted by means of screws 3. Some SMD components 4 and a connector 5 are shown as examples of components mounted on the circuit board 2.

In a cut-out 6 of circuit board 2, two RF circuit components 7 are mounted directly on the base plate 1 by cementing. At the edge of the cut-out 6, adjacent to the RF circuit components 7, several bond pads 8 are formed on the circuit board 2, from which bonding wires 9 extend to corresponding bond pads 10 of the circuit components 7. At two sides, the bond pads 8 of circuit board 2 are surrounded by bores 11 that have no metallization and are not in contact with any of the conductors of circuit board 2. The bores 11 are filled with the same electrically conductive adhesive that is used for cementing the RF circuit components 7 to base plate 1. In order to be able to press the bond pads 8 closely against base plate 1, some of the screws 3 are placed close to the bond pads 8, for example, between two groups of bond pads 8 and/or at a side of a group of bond pads 8 opposite to the cut-out 6.

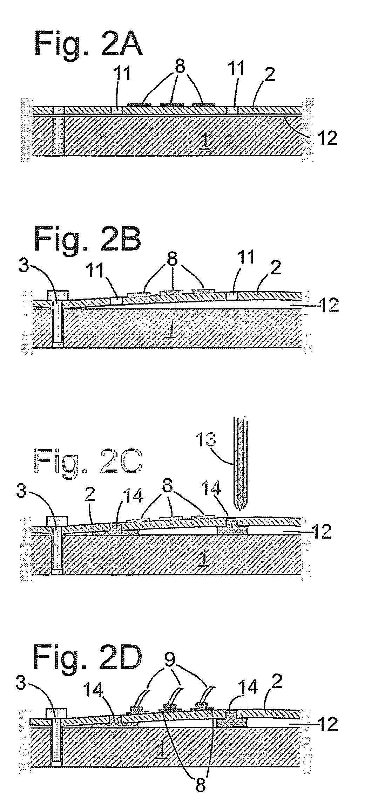

Fig. 2A shows a first stage of the manufacturing procedure of the circuit assembly of Fig. 1 by means of a partial section along line II-II of Fig. 1. In this stage, the circuit board 2 is laid loosely upon the base plate 1. Since the two facing surfaces of the base plate 1 and the circuit board 2 are never ideally flat, a narrow gap 12 exists between the two. The section also shows two bores 11 and, between these, three bond pads 8 at the upper side of circuit board 2.

Fig. 2B shows the same section as Fig. 2A in a stage in which the circuit board 2 is fixed to the ground plate 1 by means of screws 3. The heads of the screws 3 locally exert a high pressure on the circuit board 2 which causes the circuit board 2 to touch the base plate 1 in immediate vicinity of the screws 3, the circuit board 2 locally warping, so that at a larger distance from the screw the gap 12 may even have become wider. If it were intended to bond wires to the bond pads 8 by ultrasound, one would have to press the circuit board 2 flatly against the base plate 1 at the location of the bond pads 8, in order to prevent it from vibrating under the influence of the ultrasound. However, such a pressure cannot be exerted using the bonding tool as this would cause the bonding wires to be crushed at the surface of the pads 8, so that no stress-resistant contact would be created.

Fig. 2C shows the same section after filling the bores 11 with adhesive 14 through the tip 13 of a dispenser. By capillary action, the adhesive advances laterally from the bores 11 into the gap 12 and partially fills it. After hardening, i.e. curing the adhesive 14, the circuit board 2 is positively supported on the base plate 1 by the adhesive. Regions of the circuit board that are not directly supported by the adhesive, such as the central bond pad 8 in Fig. 2C, are at least made sufficiently rigid that they no longer noticeably vibrate.

The bonding wires may be contacted reproducibly and with a good quality, as shown in Fig. 2D.

It is not essential that the same electrically conductive adhesive be used for supporting the circuit board 2 on the base plate 1 that is also used for fixing the components 4 or 5 on the circuit board 2. If a conductive ground layer at the bottom side of circuit board 2 and the base plate 1 are in low impedance contact over a sufficiently large area, it is possible to use a cheap, electrically isolating adhesive. It is also possible to inject solder instead of the adhesive into the bores 11.

## Claims

1. A circuit assembly comprising a circuit board (2) having at least one hole (11) therein, at least one circuit component (7) connected to the circuit board (2) by wire bonding, and a base plate (1) on which the circuit board (2) is fixed, **characterized in that** the gap (12) between the base plate (1) and the circuit board (2) fixed to it is locally filled at the hole (11) with a filling body (14) of a material hardened in the gap (12), said filling body filling the hole (11) and extending into the gap (12) beyond the edges of the hole (11).

2. The circuit assembly according to any preceding claim, **characterized in that** the hole (11) is free from metallization.

3. The circuit assembly according to any preceding claim, **characterized in that** the hardened material is an adhesive.

4. The circuit assembly of claim 6, **characterized in that** the adhesive is electrically conductive.

5. The circuit assembly according to any preceding claim, **characterized in that** the at least one filling body (14) is located adjacent to at least one bond pad (8).

6. The circuit assembly of claim 8, **characterized in that** at least two filling bodies (14) are located at different sides of a bond pad (8).

7. A method for manufacturing a circuit assembly, comprising the steps of:
a) fixing a circuit board (2) and at least one circuit component (7) on a base plate (1),
b) applying at least one bonding wire (9) between the circuit component (7) and a bond pad (8) of the circuit board (2), and **characterized in that** between steps a) and b), a hardenable material is introduced into a gap (12) between the circuit board (2) and the base plate (1) and is hardened in the gap (12).

8. The method of claim 10, **characterized in that** the hardenable material is introduced into the gap (12) using capillary force.

9. The method of claim 10 or 11, **characterized in that** the hardenable material is introduced into the gap (12) through a hole (11) in the circuit board (2).

10. The method of any of claims 10, 11 or 12, **characterized in that** the hardenable material is an adhesive which is also used for cementing components (4, 5, 7) to the circuit board (2) and/or the base plate (1), and that the adhesive is introduced into the gap (12) and is applied to the circuit board (2) and/or the base plate (1) for cementing the components (4, 5, 7) in a same step.

11. The method of claims 10 to 13, **characterized in that** the bonding wire (9) is mounted by ultrasonic welding.

## Patentansprüche

1. Schaltungsanordnung, welche eine Leiterplatte (2) mit mindestens einer Bohrung (11) darin, mindestens eine Schaltungskomponente (7), die mit der Leiterplatte (2) durch Drahtbonden verbunden ist, und eine Grundplatte (1), auf welcher die Leiterplatte (2) befestigt ist, umfasst, **dadurch gekennzeichnet, dass** der Zwischenraum (12) zwischen der Grundplatte (1) und der an ihr befestigten Leiterplatte (2) lokal an der Bohrung (11) mit einem Füllkörper (14) aus einem in dem Zwischenraum (12) gehärteten Material gefüllt ist, wobei der Füllkörper die Bohrung (11) ausfüllt und sich über die Ränder der Bohrung (11) hinaus in den Zwischenraum (12) hinein erstreckt.

2. Schaltungsanordnung nach Anspruch 1, **dadurch gekennzeichnet, dass** die Bohrung (11) frei von Metallisierung ist.

3. Schaltungsanordnung nach einem der vorhergehenden Ansprüche, **dadurch gekennzeichnet, dass** das gehärtete Material ein Klebstoff ist.

4. Schaltungsanordnung nach Anspruch 3, **dadurch gekennzeichnet, dass** der Klebstoff elektrisch leitend ist.

5. Schaltungsanordnung nach einem der vorhergehenden Ansprüche, **dadurch gekennzeichnet, dass** der mindestens eine Füllkörper (14) mindestens einer Anschlussfläche (8) benachbart angeordnet ist.

6. Schaltungsanordnung nach Anspruch 5, **dadurch gekennzeichnet, dass** mindestens zwei Füllkörper (14) auf verschiedenen Seiten einer Anschlussfläche (8) angeordnet sind.

7. Verfahren zur Herstellung einer Schaltungsanordnung, welches die folgenden Schritte umfasst:
a) Befestigen einer Leiterplatte (2) und mindestens einer Schaltungskomponente (7) auf einer Grundplatte (1),
b) Anbringen mindestens eines Bonddrahtes (9) zwischen der Schaltungskomponente (7) und einer Anschlussfläche (8) der Leiterplatte (2),
**dadurch gekennzeichnet, dass** zwischen den Schritten a) und b) ein härtbares Material in einen Zwischenraum (12) zwischen der Leiterplatte (2) und der Grundplatte (1) eingeführt wird und in dem Zwischenraum (12) gehärtet wird.

8. Verfahren nach Anspruch 7, **dadurch gekennzeichnet, dass** das härtbare Material in den Zwischenraum (12) unter Verwendung von Kapillarkraft eingeführt wird.

9. Verfahren nach Anspruch 7 oder 8, **dadurch gekennzeichnet, dass** das härtbare Material in den Zwischenraum (12) durch eine Bohrung (11) in der Leiterplatte (2) hindurch eingeführt wird.

10. Verfahren nach einem der Ansprüche 7, 8 oder 9, **dadurch gekennzeichnet, dass** das härtbare Material ein Klebstoff ist, welcher auch verwendet wird, um Komponenten (4, 5, 7) an die Leiterplatte (2) und/oder die Grundplatte (1) zu kleben, und dass der Klebstoff in ein und demselben Schritt in den Zwischenraum (12) eingeführt wird und zum Ankleben der Komponenten (4, 5, 7) auf die Leiterplatte (2) und/oder die Grundplatte (1) aufgebracht wird.

11. Verfahren nach Anspruch 7 bis 10, **dadurch gekennzeichnet, dass** der Bonddraht (9) durch Ultraschallschweißen angebracht wird.

## Revendications

1. Ensemble de circuits comprenant une carte de circuit imprimé (2) comportant au moins un orifice (11), au moins un composant de circuit (7) connecté à la carte de circuit imprimé (2) par soudure de fils, et une plaque de socle (1) sur laquelle la carte de circuit imprimé (2) est fixée, **caractérisée en ce que** l'espace vide (12) entre la plaque de socle (1) et la carte de circuit imprimé (2) fixée à celle-ci est localement remplie au niveau de l'orifice (11) avec un corps de remplissage (14) d'un matériau durci dans l'espace vide (12), ledit corps de remplissage remplissant l'orifice (11) et s'étendant dans l'espace vide (12) au-delà des bords de l'orifice (11).

2. Ensemble de circuits selon une quelconque revendication précédente, **caractérisé en ce que** l'orifice (11) est exempt de métallisation.

3. Ensemble de circuits selon une quelconque des revendications précédentes, **caractérisé en ce que** le matériau durci est une colle.

4. Ensemble de circuits selon la revendication 6, **caractérisé en ce que** la colle est conductrice d'électricité.

5. Ensemble de circuits selon une quelconque des revendications précédentes, **caractérisé en ce que** au moins un corps de remplissage (14) est situé à côté d'au moins une plage de connexion (8).

6. Ensemble de circuits selon la revendication 8, **caractérisé en ce que** au moins deux corps de remplissage (14) sont situés sur des côtés différents d'une plage de connexion (8).

7. Procédé de fabrication d'un ensemble de circuits, comprenant les étapes consistant à :
a) fixer une carte de circuit imprimé (2) et au moins un composant de circuit (7) sur une plaque de socle (1),
b) appliquer au moins un fil de soudure (9) entre le composant de circuit (7) et une plage de connexion (8) de la carte de circuit imprimé (2), et **caractérisé en ce que** entre les étapes a) et b), un matériau durcissable est introduit dans un espace vide (12) entre la carte de circuit imprimé (2) et la plaque de socle (1) et est durci dans l'espace vide (12).

8. Procédé selon la revendication 10, **caractérisé en ce que** le matériau durcissable est introduit dans l'espace vide (12) en utilisant une force capillaire.

9. Procédé selon la revendication 10 ou 11, **caractérisé en ce que** le matériau durcissable est introduit dans l'espace vide (12) à travers un orifice (11) dans la carte de circuit imprimé (2).

10. Procédé selon une quelconque des revendications 10,11 ou 12, **caractérisé en ce que** le matériau durcissable est une colle qui est aussi utilisée pour cimenter des composants (4,5,7) à la carte de circuit imprimé (2) et/ou à la plaque de socle (1), et **en ce que** la colle est introduite dans l'espace vide (12) et est appliquée à la carte de circuit imprimé (2) et/ou la plaque de socle (1) pour cimenter les composants (4,5,7) dans une même étape.

11. Procédé selon les revendications 10 à 13, **caractérisé en ce que** le fil de soudure (9) est monté par soudure aux ultrasons.
